# FASCICULE DE BREVET EUROPEEN

(11) **EP 3 611 623 B1**
(45) Date de publication et mention de la délivrance du brevet: **10.05.2023**
(21) Numéro de dépôt: 19188499.8
(22) Date de dépôt: 26.07.2019
(51) Int. Cl.: G06F 12/02, G06F 12/06, G06F 13/16, G06F 12/0862

(54) **CONTRÔLEUR MÉMOIRE COMPRENANT DEUX BUFFERS ET UN SELECTEUR D'UN MODE DE REMPLISSAGE DESDITS BUFFERS**
SPEICHERCONTROLLER, DER ZWEI PUFFERSPEICHER UND EINE MODUSAUSWAHLEINHEIT ZUR FÜLLUNG DER PUFFERSPEICHER ENTHÄLT
MEMORY CONTROLLER COMPRISING TWO BUFFERS AND MEANS FOR SELECTING A FILLING MODE FOR SAID BUFFERS

(30) Priorité: 17.08.2018 FR 1857517
(43) Date de publication de la demande: 19.02.2020
(73) Titulaire: STMicroelectronics (Grenoble 2) SAS, 38000 Grenoble (FR)
(72) Inventeur: BRIAT, Gerald, 38000 GRENOBLE (FR)
(74) Mandataire: Cabinet Beaumont

(56) Documents cités:
- US-A1- 2014 164 713
- HUSSAIN TASSADAQ ED - MCINTOSH-SMITH SIMON ET AL: "A novel hardware support for heterogeneous multi-core memory system", JOURNAL OF PARALLEL AND DISTRIBUTED COMPUTING, ELSEVIER, AMSTERDAM, NL, vol. 106, 16 mars 2017 (2017-03-16), pages 31-49, XP085008765, ISSN: 0743-7315, DOI: 10.1016/J.JPDC.2017.02.008
- PARK JAEHYUN ET AL: "Prefetch-based dynamic row buffer management for LPDDR2-NVM devices", 2015 IFIP/IEEE INTERNATIONAL CONFERENCE ON VERY LARGE SCALE INTEGRATION (VLSI-SOC), IEEE, 5 octobre 2015 (2015-10-05), pages 98-103, XP032803865, DOI: 10.1109/VLSI-SOC.2015.7314399
- Nima Honarmand: "Main memory and DRAM", , 2015, pages 1-37, XP002791157, Extrait de l'Internet: URL:https://compas.cs.stonybrook.edu/~nhon armand/courses/sp15/cse502/slides/06-main_ mem.pdf [extrait le 2019-05-10]

## Description

### Domaine technique

La présente description concerne de façon générale les circuits électroniques, et plus particulièrement les dispositifs de réception de contenus d'emplacements mémoire, tels que les contrôleurs mémoire.

### Technique antérieure

Un contrôleur mémoire est généralement utilisé entre une mémoire et des circuits y ayant accès, par exemple dans une puce électronique de circuit intégré.

La publication "A novel hardware support for heterogeneous multi-core memory system", Hussain Tassadag, Journal of Parallel and Distributed Computing, Elsevier Amsterdam, NL, vol. 106, 16 mars 2017 (2017-03-16), pages 31-49, décrit un support matériel pour un système de mémoire multicœur hétérogène.

### Résumé de l'invention

Un mode de réalisation pallie tout ou partie des inconvénients des dispositif connus de réception de contenus d'emplacements mémoire, tels que les contrôleurs mémoire.

Ainsi, un mode de réalisation prévoit un dispositif tel que défini dans les revendications annexées.

Un autre mode de réalisation prévoit une puce électronique, comprenant un dispositif tel que revendiqué.

Un autre mode de réalisation prévoit un procédé tel que défini dans les revendications annexées.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière partielle et schématique, une puce comprenant un mode de réalisation d'un dispositif de réception de contenus d'emplacements mémoire ;
la figure 2 représente schématiquement des étapes d'un mode de réalisation d'un procédé mis en oeuvre par le dispositif de la figure 1 ;
la figure 3 représente schématiquement un exemple de mise en oeuvre du procédé de la figure 2 par une puce du type de celle de la figure 1 ;
la figure 4 représente schématiquement des étapes du procédé de la figure 2 dans l'exemple de la figure 3 ;
la figure 5 représente, de manière partielle et schématique, une puce comprenant un mode de réalisation d'un dispositif de réception de contenus d'emplacements mémoire ;
la figure 6 représente schématiquement une partie du dispositif de la figure 5 ; et
la figure 7 représente schématiquement une autre partie du dispositif de la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

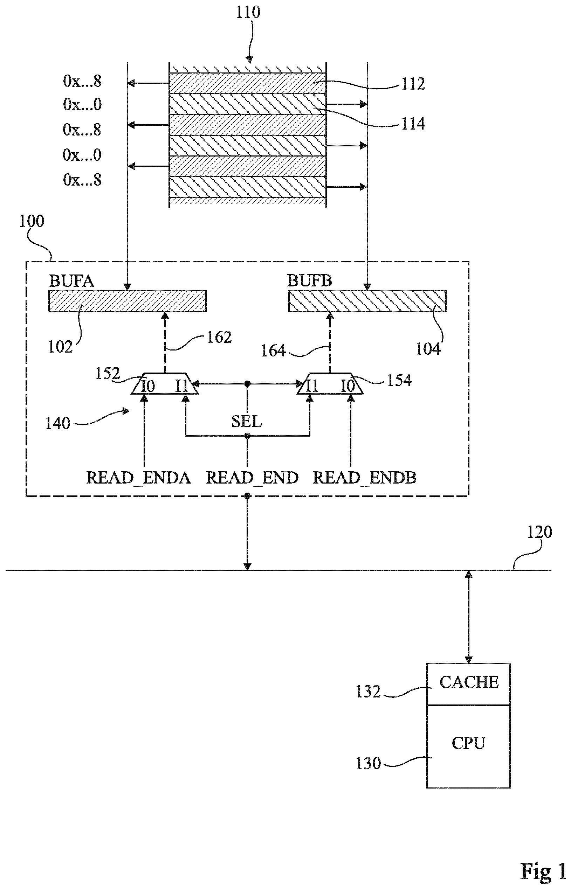

La figure 1 représente schématiquement un dispositif, par exemple une puce de circuit intégré, comprenant un mode de réalisation d'un dispositif 100 de réception de contenus d'une mémoire 110, de préférence une mémoire de type dit "flash", réinscriptible non volatile.

La puce est de préférence de type dit "Système sur une puce" ou SOC ("System On a Chip"). Des puces de type SOC sont utilisées notamment dans des applications embarquées ou mobiles, telles que la téléphonie mobile, les objets connectés, l'électroménager ou le transport.

Le dispositif 100 est relié, par exemple connecté, à un bus de données 120. De préférence, une unité de traitement de données, telle qu'un microprocesseur 130 (CPU), est reliée au bus 120. Le bus 120 permet notamment la transmission de données de la mémoire vers l'unité de traitement. Divers périphériques non représentés tels que des capteurs, ou des circuits de communication avec des éléments extérieurs à la puce, peuvent être reliés ou connectés au bus 120. De préférence, la liaison entre le dispositif 100 et le bus 120 transmet en parallèle tous les bits d'une donnée, par exemple 32 bits. De préférence, le bus de données 120 a une taille, c'est-à-dire un nombre de bits en parallèle, égal au nombre de bits de chaque donnée.

De préférence, le microprocesseur 130 comprend, ou est relié à, une mémoire cache 132 (CACHE), ou antémémoire. Une mémoire cache est une mémoire ayant par exemple un temps d'accès inférieur à celui de la mémoire 110 et servant de tampon entre le bus 120 et le microprocesseur 130.

La mémoire 110 comprend une succession d'emplacements 112 et 114. Les emplacements mémoire 112 et 114 se succèdent de manière alternée dans l'ordre de leurs adresses, de préférence leurs adresses logiques. A titre d'exemple, les emplacements 112 et 114 ont le même nombre de bits, de préférence 64 bits. Les adresses sont alors par exemple de la forme 0x...8 pour les emplacements 112, et de la forme 0x...0 pour les emplacements 114, où "0x" signifie une notation hexadécimale, et "..." représente des chiffres hexadécimaux de l'adresse considérée. Le contenu de chacun des emplacements 112 et 114 correspond à une ou plusieurs données. De préférence, chacun des emplacements 112 et 114 contient deux données. De préférence, chaque donnée correspond à 32 bits de poids faible ou fort de l'emplacement mémoire considéré.

Le dispositif 100 comprend un buffer 102 (BUFA) et un buffer 104 (BUFB). On utilise ici le terme "buffer" pour désigner un circuit tampon tel qu'une mémoire tampon, par exemple un ensemble de bascules. Chaque buffer 102, 104 contient de préférence le même nombre de bits qu'un des emplacements mémoire 112, 114.

Les buffers 102 et 104 sont remplissables par des contenus respectifs des emplacements mémoire 112 et 114. De préférence, le buffer 102 est configuré ou agencé pour être rempli par le contenu d'un emplacement sélectionnable parmi les emplacements 112. De préférence, le buffer 104 est configuré ou agencé pour être rempli par le contenu d'un emplacement sélectionnable parmi les emplacements 114.

De préférence, lors du remplissage de chacun des buffers 102 et 104, le remplissage est effectué simultanément par tous les bits du contenu d'un emplacement mémoire. En particulier, dans le cas où chaque emplacement comprend plusieurs données, le remplissage est alors effectué simultanément par toutes les données du contenu d'un emplacement mémoire.

Le dispositif 100 comprend en outre un sélecteur 140 de mode de remplissage des buffers 102 et 104. Dans un premier mode de remplissage, les buffers 102 et 104 sont remplis simultanément, c'est-à-dire que chaque buffer 102, 104 est chargé en même temps que l'autre avec le contenu respectif d'un des emplacements mémoire 112, 114. Dans un second mode de remplissage, les buffers 102 et 104 sont remplis séquentiellement, c'est-à-dire que pendant le remplissage de l'un des buffers, le contenu de l'autre est laissé inchangé.

De préférence, le sélecteur 140 comprend deux multiplexeurs 152 et 154 commandant le remplissage des buffers respectifs 102 et 104. A titre d'exemple, le remplissage des buffers 102 et 104 est commandé par des signaux respectifs 162 et 164. Les multiplexeurs 152 et 154 sont commandés par un signal SEL de sélection du mode de remplissage. Les multiplexeurs ont ici des entrées I0 et I1 sélectionnables en fonction de l'état haut ou bas du signal de commande du multiplexeur. Les entrées I0 et I1, et les niveaux bas et haut des signaux de commande peuvent être échangés. Les entrées I1 des multiplexeurs 152 et 154 sont reliées à un noeud d'application d'un même signal READ_END. Les entrées I0 des multiplexeurs 152 et 154 sont par exemple reliées à des noeuds d'application de signaux différents respectifs READ_ENDA et READ_ENDB. Le dispositif est de préférence configuré pour que les signaux READ_ENDA et READ_ENDB ne soient pas émis simultanément, comme ceci est illustré ci-après.

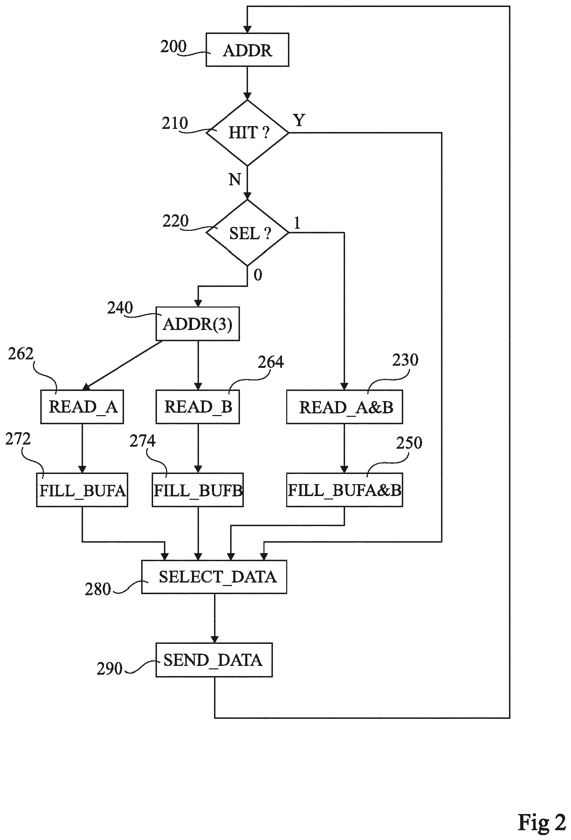

La figure 2 représente schématiquement des étapes d'un mode de réalisation d'un procédé mis en oeuvre par le dispositif de réception 100 de la figure 1.

De préférence, à une étape 200, le dispositif 100 reçoit une adresse de requête ADDR, de préférence une adresse logique. Par exemple, cette adresse est émise par le microprocesseur 130 et/ou la mémoire cache 132 lorsqu'ils ont besoin d'une donnée située dans la mémoire 110 à l'adresse de requête. L'adresse de requête ADDR peut aussi être émise par tout dispositif relié au bus 120, tel qu'un dispositif d'accès direct à la mémoire de type DMA ("Direct Memory Access"). Pour recevoir l'adresse de requête, le dispositif 100 est de préférence relié, par exemple connecté, à un bus d'adresses non représenté. Le microprocesseur 130 est alors relié au bus d'adresses.

De préférence, à une étape 210 (HIT?), le dispositif 100 détermine si l'un des buffers 102 et 104 contient déjà la donnée de l'adresse correspondante dans la mémoire. Si tel n'est pas le cas (sortie N du bloc 210), le procédé passe à une étape 220.

A l'étape 220, le mode de remplissage est sélectionné entre mode de remplissage simultané (par exemple lorsque le signal SEL est au niveau haut '1') et mode de remplissage séquentiel (par exemple lorsque le signal SEL est au niveau bas '0') . Si le mode de remplissage simultané est sélectionné, le procédé passe à une étape 230. Si le mode de remplissage séquentiel est sélectionné, le procédé passe à une étape 240. L'ordre des étapes 210 et 220 peut être échangé.

A l'étape 230 (READ_A&B), les contenus des emplacements 112 et 114 sont lus dans la mémoire 110, de préférence simultanément. De préférence, ces emplacements sont consécutifs et contiennent la donnée située à l'adresse de requête. De préférence, lorsque la lecture est terminée, un signal de fin de lecture est émis. Ce signal de fin de lecture est de préférence le signal READ_END de commande de remplissage simultané des buffers. Le procédé passe alors à une étape 250 (FILL_BUFA&B) de remplissage simultané des buffers 102 et 104.

De préférence, à l'étape 240 (ADDR(3)), le dispositif 100 sélectionne, entre d'une part l'ensemble des emplacements 112 et d'autre part l'ensemble des emplacements 114, l'ensemble qui contient la donnée située à l'adresse de requête. Dans l'exemple d'emplacements mémoire 112 et 114 contenant chacun 64 bits, le dispositif détermine par exemple le quatrième bit en partant des poids faible (bit ADDR(3), les bits étant généralement numérotés à partir de 0). Si le bit ADDR(3) est égal à 0, la donnée contenue à l'adresse de requête est située dans un des emplacements 112. Si le bit ADDR(3) est égal à 1, la donnée contenue à l'adresse de requête est située dans un des emplacements 114. Cet exemple peut être adapté pour tout nombre de bits de chaque emplacement 112, 114, par exemple 32 ou 128 bits.

Si la donnée contenue à l'adresse de requête est située dans un des emplacements 112, le contenu de cet emplacement 112 est de préférence lu à une étape 262 (READ_A). De préférence, lorsque la lecture est terminée, un signal de fin de lecture est émis. Ce signal est de préférence le signal READ_ENDA de commande du remplissage du seul buffer 102. Le procédé passe à une étape 272 (FILL_BUFA) de remplissage du buffer 102 par le contenu de l'emplacement 112 considéré. Le contenu du buffer 104 est laissé inchangé à ce stade.

Si la donnée contenue à l'adresse de requête est située dans un des emplacements 114, le contenu de cet emplacement 114 est de préférence lu à une étape 264 (READ_B). De préférence, lorsque la lecture est terminée, un signal de fin de lecture est émis. Ce signal est de préférence le signal READ_ENDB de commande du remplissage du seul buffer 104. Le procédé passe à une étape 274 (FILL_BUFA) de remplissage du buffer 104 par le contenu de l'emplacement 114 considéré. Pendant ce temps, le contenu du buffer 102 n'est pas modifié.

De préférence, après les étapes 250, 272 et 274, le procédé passe à une étape 280 (SELECT_DATA) . A cette étape, le dispositif 100 détermine la position, dans les buffers 102 et 104, de la donnée correspondant à l'adresse de requête. De préférence, quatre positions sont possibles : les bits de poids faible du buffer 102 ; les bits de poids fort du buffer 102 ; les bits de poids faible du buffer 104 ; et les bits de poids fort du buffer 104.

De préférence, à une étape 290 (SEND_DATA) suivante, la donnée contenue dans les buffers 102 et 104 à la position déterminée à l'étape 280 est envoyée sur le bus de données 120. La donnée envoyée peut ensuite être utilisée par le microprocesseur 130 et/ou la mémoire cache 132. Après l'étape 290, le procédé reprend de préférence à l'étape 200 pour recevoir une nouvelle adresse de requête.

Si, à l'étape 210, la donnée située à la nouvelle adresse de requête est déjà dans l'un des buffers 102 et 104 (sortie Y du bloc 210), le procédé passe directement à l'étape 280.

De préférence, le signal SEL est modifié à une étape non représentée du procédé. Le procédé en boucle ainsi mis en oeuvre comprend des remplissages simultanés des buffers, et des remplissages de seulement un des deux buffers puis de seulement l'autre des deux buffers. Le procédé permet d'envoyer successivement sur le bus 120 les données situées à diverses adresses de requête reçues aux étapes 200.

Dans un mode de réalisation préféré, les emplacements 112 sont situés dans une première banque de mémoire, et les emplacements 114 sont situés dans une deuxième banque de mémoire. Lorsque le mode de remplissage sélectionné est le remplissage séquentiel, pour chaque adresse de requête, on lit au plus un contenu dans une seule des deux banques. Ceci permet de réduire la consommation d'énergie par rapport à la lecture du contenu des deux banques pour chaque adresse de requête. Lorsque le mode de remplissage sélectionné est le remplissage simultané, les deux buffers remplis permettent, par rapport à des remplissages séquentiels, de gagner du temps par exemple lorsque l'unité de traitement 130 et/ou la mémoire cache 132 ont besoin de données situées à des adresses consécutives. On peut ainsi optimiser le compromis entre la vitesse d'exécution et la consommation d'énergie.

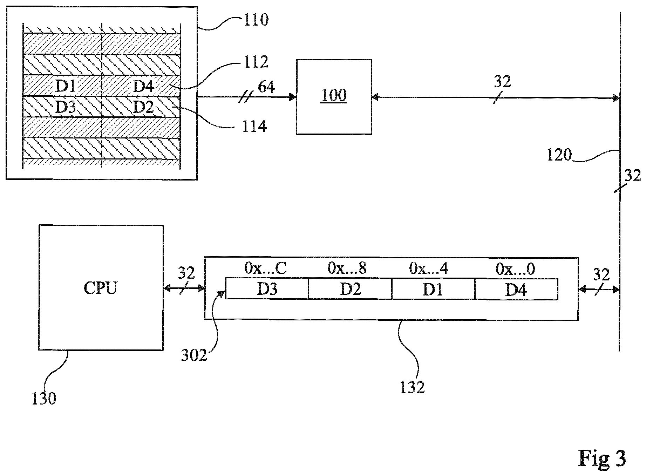

La figure 3 représente schématiquement un exemple de mise en oeuvre du procédé de la figure 2 par une puce du type de celle de la figure 1, lorsque les buffers sont remplis séquentiellement.

Dans cet exemple, les données sont des mots de 32 bits, le bus de données 120 est un bus de 32 bits, les emplacements 112 et 114 de la mémoire 110 contiennent chacun 64 bits, et la mémoire cache 132 contient des emplacements 302 contenant chacun 128 bits. Ainsi, chaque emplacement 302 de la mémoire cache peut contenir quatre données. Chaque emplacement est par exemple destiné à recevoir les données situées dans la mémoire 110 à des adresses logiques respectives 0x...0, 0x...4, 0x...8, et 0x...C.

On suppose que le microprocesseur a besoin de la donnée située à l'adresse logique 0x...4, cette donnée n'étant pas présente dans la mémoire cache 132. On remplit alors l'ensemble d'un des emplacements 302 de la mémoire cache. Pour cela, des requêtes successives sont envoyées au dispositif 100 pour qu'il envoie successivement les quatre données correspondantes sur le bus 120. La première requête concerne l'adresse 0x...4. Ceci permet que la donnée D1 correspondante soit disponible le plus tôt possible pour le microprocesseur. Les requêtes suivantes ont successivement les adresses 0x...8, 0x...C et 0x..0.

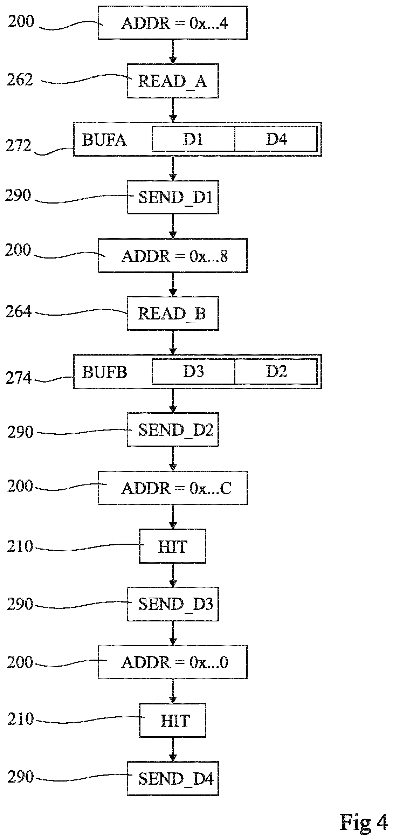

La figure 4 représente schématiquement des étapes du procédé de la figure 2 dans l'exemple de la figure 3.

L'adresse de requête 0x...4 est reçue à l'étape 200 (ADDR = 0x...4). La donnée D1 située à l'adresse de requête 0x...4 est contenue dans un des emplacements 112. Cet emplacement 112 contient en outre la donnée D4 située à l'adresse 0x...0. Le procédé passe par l'étape 262 de lecture du contenu de cet emplacement 112 (READ_A), puis par l'étape 272 de remplissage du buffer 102 par ce contenu. Il en résulte que le buffer 102 contient alors les deux données D1 et D4. La donnée D1 est envoyée à l'étape 290 suivante (SEND_D1).

Ensuite, l'adresse de requête 0x...8 est reçue à l'étape 200 (ADDR = 0x...8). La donnée D2 située à l'adresse de requête 0x...8 est située dans un des emplacements 114. Cet emplacement 114 contient en outre la donnée D3 située à l'adresse 0x...C. Le procédé passe par l'étape 264 de lecture du contenu de cet emplacement 114 (READ_B), puis par l'étape 274 de remplissage du buffer 104 par ce contenu. Il en résulte que le buffer 104 contient alors les deux données D2 et D3. La donnée D2 est envoyée à l'étape 290 suivante (SEND_D2).

Après cela, l'adresse de requête 0x...C est reçue à l'étape 200 (ADDR = 0x...C). Après l'étape 210 (HIT), du fait que la donnée correspondante D3 est contenue dans le buffer 104, le procédé passe directement à l'étape 290 d'envoi de la donnée D3 (SEND_D3).

Enfin, l'adresse de requête 0x...0 est reçue à l'étape 200 (ADDR = 0x...0). Après l'étape 210 (HIT), du fait que la donnée correspondante D4 est contenue dans le buffer 102, le procédé passe directement à l'étape 290 d'envoi de la donnée D4 (SEND_D4).

Ainsi, les quatre données D1, D2, D3 et D4 sont envoyées dans cet ordre en effectuant seulement une étape de lecture du contenu des emplacements 112 et une étape de lecture du contenu des emplacements 114. S'il n'y avait qu'un seul buffer remplissable par un contenu des emplacements 112 et 114, il aurait fallu trois étapes de lecture. Le procédé permet donc d'envoyer des contenus de la mémoire plus rapidement qu'avec un seul buffer. En outre, on peut améliorer le compromis entre vitesse d'exécution et consommation d'énergie, par rapport à un dispositif ayant un mode de fonctionnement où deux buffers sont remplis simultanément et un mode de fonctionnement où un seul des deux buffers peut être rempli.

Le procédé est particulièrement rapide pour d'autres successions d'adresses de requêtes que celle présentée dans l'exemple des figures 3 et 4. Cet avantage existe en particulier dans le cas où la mémoire cache 132 est omise et le microprocesseur 130 a besoin alternativement de données contenues dans un même emplacement 112 et un même emplacement 114. Dans ce cas, une fois les buffers 102 et 104 remplis, les données sont envoyées sur le bus 120 sans étape de lecture du contenu de la mémoire.

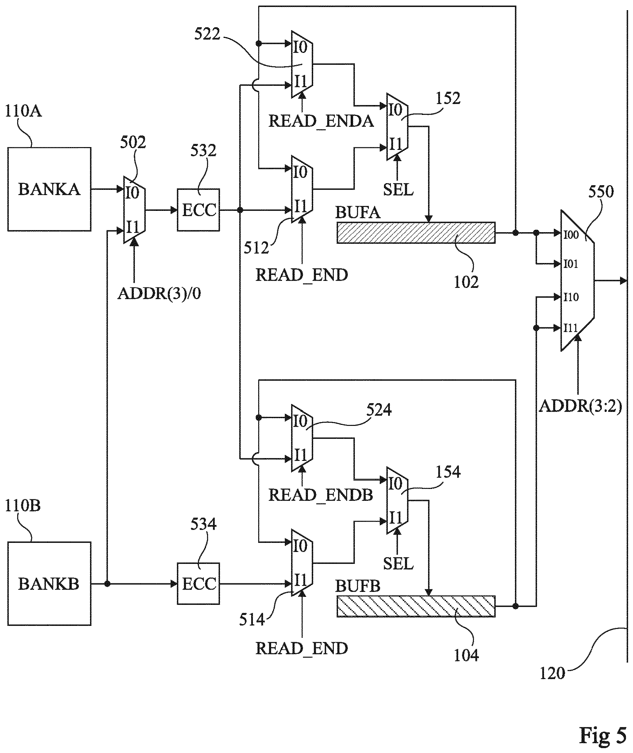

La figure 5 représente, de manière partielle et schématique, une puce comprenant un mode de réalisation d'un dispositif de réception du contenu d'emplacements mémoire.

La mémoire 110 comprend de préférence une banque mémoire 110A (BANKA), dans laquelle sont situés les emplacements 112, et une banque mémoire 110B (BANKB), dans laquelle sont situés les emplacements 114.

De préférence, la banque 110A fournit le contenu d'un emplacement mémoire à une entrée I0 d'un multiplexeur 502. Le contenu est fourni après avoir été sélectionné par son adresse et lu dans la mémoire. A titre d'exemple, la banque 110B fournit de manière similaire le contenu d'un emplacement mémoire à une entrée I1 du multiplexeur 502. Le multiplexeur 502 est par exemple commandé par un signal ADDR(3)/0. Le signal ADDR(3)/0 a par exemple un niveau bas lorsque le mode de remplissage simultané est sélectionné. De préférence, lorsque le mode de remplissage séquentiel est sélectionné, le niveau du signal ADDR(3)/0 permet de sélectionner la banque qui contient la donnée située à l'adresse de requête ADDR. Le signal ADDR(3)/0 correspond alors de préférence au bit ADDR(3). La sortie du multiplexeur 502 est reliée à des entrées I1 de multiplexeurs 512, 522 et 524. A titre d'exemple, un circuit de correction d'erreur 532 (ECC) est situé entre la sortie du multiplexeur 502 et les entrées des multiplexeurs 512, 522 et 524. Les multiplexeurs 512 et 522 reçoivent chacun sur une entrée I0 le contenu du buffer 102. Le multiplexeur 512 est commandé par le signal READ_END. Le multiplexeur 522 est commandé par le signal READ_ENDA. Le multiplexeur 152 (figure 1) reçoit alors les sorties des multiplexeurs 512 et 522.

De préférence, le contenu fourni par la banque 110B est reçu par une entrée I1 d'un multiplexeur 514. A titre d'exemple, un circuit de correction d'erreur 534 (ECC) est situé entre la sortie de la banque 110B et l'entrée I1 du multiplexeur 514. Les multiplexeurs 514 et 524 reçoivent chacun sur une entrée I0 le contenu du buffer 104. Le multiplexeur 514 est commandé par le signal READ_END. Le multiplexeur 524 est commandé par le signal READ_ENDB. Le multiplexeur 154 (figure 1) reçoit alors les sorties des multiplexeurs 514 et 524.

A titre d'exemple, les bits de poids faible du buffer 102 sont reliés à une entrée I00 d'un multiplexeur 550 ; les bits de poids fort du buffer 102 sont reliés à une entrée I01 du multiplexeur 550 ; les bits de poids faible du buffer 104 sont reliés à une entrée I10 du multiplexeur 550 ; et les bits de poids fort du buffer 104 sont reliés à une entrée I11 du multiplexeur 550. Le multiplexeur 550 est par exemple commandé par l'ensemble ADDR(3:2) des troisième et quatrième bits, en partant des poids faibles, de l'adresse de requête. De préférence, les entrées I00, I01, I10 et I11 sont sélectionnées selon l'état respectif '00', '01', '10' et '11' des bits ADDR(3:2). La sortie du multiplexeur 550 est reliée au bus 120.

De préférence, les liaisons entre les banques 110A et 110B, les multiplexeurs 152, 154, 502, 512, 514, 522 et 524, et les buffers 102 et 104 peuvent transmettre en parallèle tous les bits d'un contenu d'emplacement mémoire.

De préférence, les liaisons entre les buffers 102 et 104, le multiplexeur 550 et le bus 120 peuvent transmettre en parallèle tous les bits d'une donnée, de préférence 32 bits.

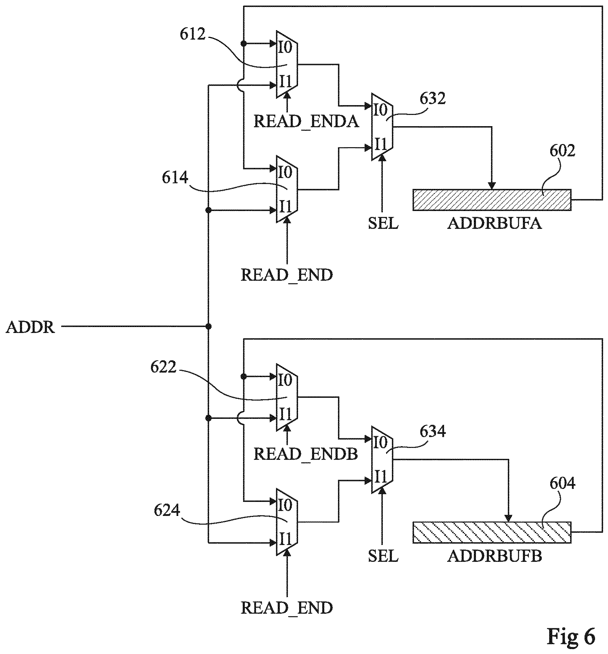

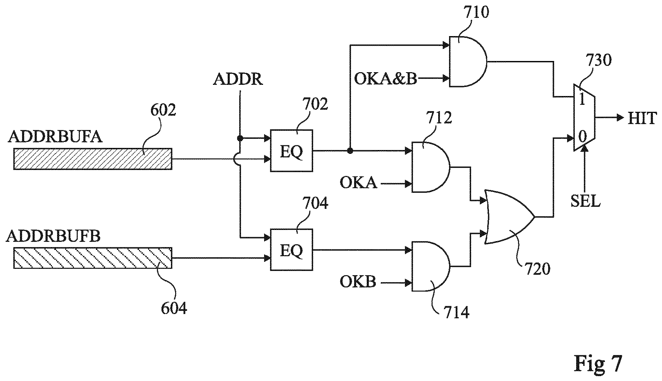

Les figures 6 et 7 représentent schématiquement des parties du dispositif de réception de la figure 5, permettant la mise en oeuvre de l'étape 210 (HIT?) du procédé de la figure 2.

Le dispositif comprend deux buffers 602 (ADDRBUFA) et 604 (ADDRBUFB) de stockage de l'adresse de requête. L'adresse de requête est reçue par des entrées I1 de multiplexeurs 612, 614, 622 et 624. Les multiplexeurs 612 et 614 reçoivent le contenu du buffer 602 sur des entrées I0. Les sorties des multiplexeurs 612 et 614 sont reliées aux entrées d'un multiplexeur 632 commandé par le signal SEL. Les multiplexeurs 622 et 624 reçoivent le contenu du buffer 604 sur des entrées I0. Les sorties des multiplexeurs 622 et 624 sont reliées aux entrées d'un multiplexeur 634 commandé par le signal SEL. Les multiplexeurs 612 et 622 sont commandés respectivement par les signaux READ_ENDA et READ_ENDB. Les multiplexeurs 614 et 624 sont commandés ensemble par le signal READ_END.

En fonctionnement, lorsque le mode de remplissage simultané des buffers est sélectionné, les deux buffers 602 et 604 sont remplis avec l'adresse de requête associée au remplissage des buffers 102 et 104 (étape 250 du procédé de la figure 2). Lorsque le mode de remplissage séquentiel est sélectionné, le buffer 602 ou 604 est rempli avec l'adresse de requête associée au remplissage du buffer respectif 102 ou 104 (étape 262 ou 264). Lors du remplissage d'un des deux buffers 602 et 604, le contenu de l'autre des deux buffers 602 et 604 est laissé inchangé.

Le contenu des buffers 602 et 604 correspond ainsi à l'adresse de requête associée au remplissage des buffers 602 et 604.

En figure 7, le buffer 602 est relié à une entrée d'un circuit 702 (EQ) recevant l'adresse de requête sur une autre entrée. Le circuit 702 est un circuit de vérification d'égalité entre les valeurs reçues sur ses deux entrées. De préférence, le circuit 702 fournit un niveau haut lorsque les valeurs reçues sont égales, et un niveau bas lorsque les valeurs reçues sont différentes. La sortie du circuit 702 est reliée à une entrée d'une porte ET 710. La porte ET 710 reçoit un signal OKA&B à une autre entrée. La sortie du circuit 702 est en outre reliée à une porte ET 712. La porte ET 712 reçoit un signal OKA à une autre entrée.

Le buffer 604 est relié à une entrée d'un circuit 704 (EQ) de vérification d'égalité entre deux entrées. Le circuit 704 reçoit l'adresse de requête sur l'autre de ses deux entrées. La sortie du circuit 704 est reliée à une entrée d'une porte ET 714. La porte ET 714 reçoit un signal OKB à une autre entrée.

Les sorties des portes ET 712 et 714 sont reliées à l'entrée d'une porte OU 720. Les sorties de la porte OU 720 et de la porte ET 710 sont reliées à un multiplexeur 730. Le multiplexeur 730 est commandé par le signal SEL. Le multiplexeur 730 fournit un signal HIT.

Chacun des signaux OKA, OKB et OKA&B est activé, par exemple mis à un niveau haut, lorsque des conditions de validité sont remplies concernant : les buffers 102 et 602 pour le signal OKA ; les buffers 104 et 604 pour le signal OKB ; et ces quatre buffers pour le signal OKA&B. De telles conditions sont par exemple l'absence de remplissage en cours des buffers concernés, de lecture en cours de la mémoire, la présence d'une donnée valide dans les buffers, etc.

En fonctionnement, le signal HIT est activé lorsque la donnée située dans la mémoire à l'adresse de requête se trouve déjà dans le contenu des buffers 102 et 104. Le signal HIT est alors utilisé à l'étape 210 (HIT?) du procédé de la figure 2.

On peut utiliser, à la place des circuits des figures 6 et 7, tout circuit permettant de réaliser l'étape 210 du procédé de la figure 2. De préférence, un tel circuit est configuré pour mémoriser dans des buffers les adresses des contenus remplissant les buffers. Le circuit détermine ensuite si l'adresse mémorisée correspond à celle d'une nouvelle requête. A titre de variante, l'étape 210 peut être omise.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données cidessus.

## Revendications

1. Dispositif comprenant :
un premier et un deuxième buffers de contenu (102, 104) remplissables par des contenus respectifs de premier et deuxième emplacements mémoire (112, 114), lesdits emplacements mémoires se succédant de manière alternée dans l'ordre de leurs adresses ;
deux buffers d'adresse (602, 604) remplissables séquentiellement par des adresses des contenus respectifs des premiers et deuxièmes emplacements mémoire et
un sélecteur (140) d'un mode de remplissage entre un remplissage simultané dans lequel les deux buffers d'adresse sont remplis avec une adresse de requête associée au remplissage des buffers de contenu de telle sorte que lesdits premier et deuxième buffers de contenu sont remplis en même temps, et un remplissage séquentiel dans lequel un des buffers d'adresse est rempli avec une adresse de requête associée au buffer de contenu correspondant et, pendant le remplissage d'un des premier et deuxième buffers d'adresse, le contenu de l'autre est laissé inchangé, de telle sorte que pendant le remplissage du premier buffer de contenu, le contenu de l'autre buffer de contenu est laissé inchangé.

2. Dispositif selon la revendication 1, dans lequel le contenu de chaque emplacement (112, 114) comprend plusieurs données, de préférence deux données, chacun desdits buffers (102, 104) étant configuré pour être rempli simultanément par lesdites plusieurs données.

3. Dispositif selon la revendication 2, comprenant un circuit d'envoi (550) d'une des données sur un bus (120) de même taille que les données.

4. Dispositif selon l'une quelconque des revendications 1 à 3, dans lequel les adresses des emplacements des deux buffers de contenu (102, 104) sont des adresses logiques.

5. Dispositif selon l'une quelconque des revendications 1 à 4, configuré pour que le remplissage séquentiel desdits buffers de contenu soit un remplissage par les contenus d'emplacements mémoire consécutifs.

6. Puce électronique, comprenant un dispositif selon l'une quelconque des revendications 1 à 5.

7. Procédé comprenant des premier (250) et deuxième (272, 274) remplissages d'un premier et d'un deuxième buffers de contenu (102, 104) par des contenus respectifs de premier et deuxième emplacements mémoire, lesdits emplacements mémoire se succédant de manière alternée dans l'ordre de leurs adresses, le premier remplissage étant un remplissage simultané dans lequel les deux buffers d'adresse sont remplis avec une adresse de requête associée au remplissage des buffers de contenu de telle sorte que lesdits buffers de contenu sont remplis en même temps, et le deuxième remplissage étant un remplissage séquentiel dans lequel un buffer d'adresse, parmi deux buffers d'adresse des contenus respectifs des premiers et deuxièmes emplacements mémoire, est rempli avec une adresse de requête associée au buffer de contenu correspondant, le contenu de l'autre buffer d'adresse étant laissé inchangé, de telle sorte que pendant le remplissage du premier buffer de contenu, le contenu de l'autre buffer de contenu est laissé inchangé.

8. Procédé selon la revendication 7, dans lequel le contenu de chaque emplacement (112, 114) comprend plusieurs données, de préférence deux données, chacun desdits buffers de contenu (102, 104) étant rempli simultanément par lesdites plusieurs données au cours des premier (250) et deuxième (272, 274) remplissages.

9. Procédé selon la revendication 8, comprenant une étape d'envoi d'une des données sur un bus (120) de même taille que les données.

10. Procédé selon l'une quelconque des revendications 7 à 9, dans lequel les deux buffers de contenu (102, 104) sont remplis respectivement par des premiers (112) et deuxièmes (114) emplacements ayant des adresses alternées, de préférence logiques.

11. Procédé selon l'une quelconque des revendications 7 à 10, comprenant une étape de mémorisation dans un buffer supplémentaire (602, 604) d'une des adresses des premiers (112) et deuxièmes (114) emplacements.

12. Procédé selon la revendication 11, comprenant une étape de vérification d'égalité (702, 704) entre une adresse de requête et l'adresse stockée à l'étape de mémorisation.

13. Procédé selon la revendication 12, dans lequel la présence d'une étape (262, 264) de lecture du contenu d'un des emplacements (112, 114) est fonction du résultat de l'étape de vérification d'égalité (702, 704).

14. Procédé selon l'une quelconque des revendications 7 à 13, dans lequel, audit premier remplissage (250), lesdits buffers de contenu (102, 104) sont remplis par les contenus respectifs d'emplacements mémoire consécutifs.

## Patentansprüche

1. Vorrichtung, die Folgendes aufweist:
einen ersten und einen zweiten Inhaltspuffer (102, 104), die mit dem Inhalt eines ersten und eines zweiten Speicherplatzes (112, 114) gefüllt werden können, wobei die Speicherplätze in der Reihenfolge ihrer Adressen wechselnd aufeinander folgen;
zwei Adresspuffer (602, 604), die sequentiell mit den jeweiligen Inhaltsadressen der ersten und zweiten Speicherplätze gefüllt werden können, und
einen Selektor (140) für einen Füllmodus zwischen einem gleichzeitigen Füllen, bei dem die beiden Adresspuffer mit einer Anforderungsadresse gefüllt werden, die dem Füllen der Inhaltspuffer zugeordnet ist, so dass die ersten und zweiten Inhaltspuffer gleichzeitig gefüllt werden, und einem sequentiellen Füllen, bei dem einer der Adresspuffer mit einer Anforderungsadresse gefüllt wird, die dem entsprechenden Inhaltspuffer zugeordnet ist, und beim Füllen eines der ersten und zweiten Adresspuffer der Inhalt des anderen unverändert gelassen wird, so dass beim Füllen des ersten Inhaltspuffers der Inhalt des anderen Inhaltspuffers unverändert gelassen wird.

2. Vorrichtung nach Anspruch 1, wobei der Inhalt jedes Platzes (112, 114) mehrere Daten, vorzugsweise zwei Daten, aufweist, wobei jeder der Puffer (102, 104) konfiguriert ist zum gleichzeitigen Füllen mit den mehreren Daten.

3. Vorrichtung nach Anspruch 2 aufweisend eine Schaltung zum Senden (550) einer der Daten auf einem Bus (120) mit der gleichen Größe wie die Daten.

4. Vorrichtung nach einem der Ansprüche 1 bis 3, wobei die Adressen der Plätze der beiden Inhaltspuffer (102, 104) logische Adressen sind.

5. Vorrichtung nach einem der Ansprüche 1 bis 4, die so konfiguriert ist, dass das sequentielle Füllen der Inhaltspuffer ein Füllen mit den Inhalten aufeinanderfolgender Speicherplätze ist.

6. Elektronischer Chip aufweisend eine Vorrichtung nach einem der Ansprüche 1 bis 5.

7. Verfahren aufweisend ein erstes (250) und ein zweites (272, 274) Füllen eines ersten und eines zweiten Inhaltspuffers (102, 104) mit dem jeweiligen Inhalt eines ersten und eines zweiten Speicherplatzes, wobei die Speicherplätze in der Reihenfolge ihrer Adressen wechselnd aufeinander folgen, wobei das erste Füllen ein gleichzeitiges Füllen ist, bei dem die beiden Adresspuffer mit einer Anforderungsadresse gefüllt werden, die dem Füllen der Inhaltspuffer zugeordnet ist, so dass die Inhaltspuffer gleichzeitig gefüllt werden, und wobei das zweite Füllen ein sequentielles Füllen ist, bei dem ein Adresspuffer von zwei Adresspuffern der jeweiligen Inhalte der ersten und zweiten Speicherplätze mit einer Anforderungsadresse gefüllt wird, die dem entsprechenden Inhaltspuffer zugeordnet ist, wobei der Inhalt des anderen Adressinhalts unverändert gelassen wird, so dass während des Füllens des ersten Inhaltspuffers der Inhalt des anderen Inhaltspuffers unverändert gelassen wird.

8. Verfahren nach Anspruch 7, wobei der Inhalt jedes Speicherplatzes (112, 114) mehrere Daten, vorzugsweise zwei Daten, umfasst, wobei jeder der Inhaltspuffer (102, 104) während des ersten (250) und zweiten (272, 274) Füllens gleichzeitig mit den mehreren Daten gefüllt wird.

9. Verfahren nach Anspruch 8 aufweisend einen Schritt des Sendens einer der Daten über einen Bus (120) mit der gleichen Größe wie die Daten.

10. Verfahren nach einem der Ansprüche 7 bis 9, wobei die beiden Inhaltspuffer (102, 104) jeweils mit ersten (112) und zweiten (114) Speicherplätzen gefüllt werden die wechselnde, vorzugsweise logischen Adressen haben.

11. Verfahren nach einem der Ansprüche 7 bis 10 aufweisend einen Schritt des Speicherns einer der Adressen der ersten (112) und zweiten (114) Speicherplätze in einem zusätzlichen Puffer (602, 604) aufweist.

12. Verfahren nach Anspruch 11, aufweisend einen Schritt der Gleichheitsprüfung (702, 704) zwischen einer Anforderungsadresse und der während des Speicherschritts gespeicherten Adresse.

13. Verfahren nach Anspruch 12, wobei das Vorhandensein eines Schritts (262, 264) zum Lesen des Inhalts eines der Speicherplätze (112, 114) eine Funktion des Ergebnisses des Schritts der Gleichheitsprüfung (702, 704) ist.

14. Verfahren nach einem der Ansprüche 7 bis 13, wobei während des ersten Füllens (250) die Inhaltspuffer (102, 104) mit den jeweiligen Inhalten aufeinanderfolgender Speicherplätze gefüllt werden.

## Claims

1. A device comprising:
a first and a second content buffers (102, 104) fillable with the contents of a first and a second memory locations (112, 114), said memory locations alternating each other in sequence of their addresses;
two address buffers (602, 604) sequentially fillable with respective content addresses of the first and second memory locations and
a selector (140) of a filling mode between simultaneous filling during which the two address buffers are filled with a request address associated to the filing of the content buffers so that said first and second content buffers are simultaneously filled, and of a sequential filling during which one of the address buffer is filled with a request address associated to the corresponding content buffer, and, when filling one of the first and second address buffers, the content of the other is left unchanged, so that, during the filling of the first content buffer, the content of the other content buffer is left unchanged.

2. The device according to claim 1, wherein the content of each location (112, 114) comprises several data, preferably two data, each of said buffers (102, 104) being configured to be filled simultaneously with said several data.

3. The device according to claim 2, comprising a circuit for sending (550) one of the data on a bus (120) of the same size as the data.

4. The device according to any one of claims 1 to 3, wherein the addresses of the locations of the two content buffers (102, 104) are logical addresses.

5. The device according to any one of claims 1 to 4, being configured so that the sequential filling of said content buffers is a filling with the contents of consecutive memory locations.

6. An electronic chip, comprising a device according to any one of claims 1 to 5.

7. A method comprising first (250) and second (272, 274) fillings of a first and a second content buffers (102, 104) with respective contents of first and second memory locations, said memory locations alternating each other in sequence of their addresses, the first filling being a simultaneous filling during which the two address buffers are filled with a request address associated to the filings of the content buffers so that said content buffers are simultaneously filled, and the second filling being a sequential filling during which an address buffer, among two address buffers of the respective contents of the first and second memory locations, is filled with a request address associated to the corresponding content buffer, the content of the other address content being left unchanged, so that, during the filling of the first content buffer, the content of the other content buffer is left unchanged.

8. The method according to claim 7, wherein the contents of each location (112, 114) comprises multiple data, preferably two data, each of said content buffers (102, 104) being filled simultaneously with said multiple data during the first (250) and second (272, 274) fillings.

9. The method according to claim 8, comprising a step of sending one of the data over a bus (120) of the same size as the data.

10. The method according to any one of claims 7 to 9, wherein the two content buffers (102, 104) are respectively filled with first (112) and second (114) locations having alternate addresses, preferably logical.

11. The method according to any one of claims 7 to 10, comprising a step of storing in an additional buffer (602, 604) one of the addresses of the first (112) and second (114) locations.

12. The method according to claim 11, comprising a step of equality checking (702, 704) between a request address and the address stored during the storing step.

13. The method according to claim 12, wherein the presence of a step (262, 264) of reading the contents of one of the locations (112, 114) is a function of the result of the step of equality checking (702, 704).

14. The method according to any of claims 7 to 13, wherein, during said first filling (250), said content buffers (102, 104) are filled with the respective contents of consecutive memory locations.
